# EUROPEAN PATENT APPLICATION

(11) **EP 2 636 712 A1**
(43) Date of publication of application: **11.09.2013**
(21) Application number: 12158418.9
(22) Date of filing: 07.03.2012
(51) Int. Cl.: C09J 7/02, H01L 21/02, H01L 23/48

(54) **Pressure-sensitive adhesive tape for resin encapsulation and method for producing resin encapsulation type semiconductor device**

(71) Applicant: Nitto Denko Corporation, Ibaraki-shi, Osaka 567-8680 (JP)
(72) Inventor: Kondo, Hiroyuki, Osaka (JP); Hoshino, Shinji, Osaka (JP); Arimitsu, Yukio, Osaka (JP); Nishio, Akinori, Osaka (JP)
(74) Representative: Grünecker, Kinkeldey, Stockmair & Schwanhäusser

(57) **Abstract**

The present invention provides a pressure-sensitive adhesive tape for resin encapsulation in production of a resin encapsulation type semiconductor device, which includes a base material layer which does not have a glass transition temperature in a temperature region of 260°C or lower and a pressure-sensitive adhesive layer laminated on the base material layer, and a method for producing a resin encapsulation type semiconductor device using the pressure-sensitive adhesive tape. The pressure-sensitive adhesive tape according to the present invention highly prevents resin leakage even under severe conditions as in MAP-QFN production process, does not affect certainty of wire bonding and has excellent peelability after resin encapsulation.

## Description

### FIELD OF THE INVENTION

The present invention relates to a pressure-sensitive adhesive tape for resin encapsulation and a method for producing a resin encapsulation type semiconductor device.

### BACKGROUND OF THE INVENTION

In recent years, CSP (Chip Size/Scale Package) technology is noted in mounting technology of LSI. Of the technology, a package in a form where lead terminals are included in the package, as represented by QFN (Quad Flat Non-leaded package) is particularly noted in terms of reduction in size and high integration.
In such QFN, production methods that can remarkably improve productivity per lead frame area are particularly noted. Such methods includes a production method including arranging plural chips for QFN on a die pad of a lead frame, en bloc encapsulating the same with an encapsulation resin in a cavity of a mold, and then cutting the same to divide into individual QFN structures.

In the production method of QFN in which plural semiconductor chips are en bloc encapsulated, a region of a lead frame clamped by a molding mold at the resin encapsulation is only a part of an outside of a resin encapsulation region which completely covers a package pattern area. Therefore, in the package pattern area, particularly, in its central part, the back face of the lead frame cannot be pressed down to the molding mold with sufficient pressure, and it is very difficult to prevent leakage of an encapsulation resin into the back face of the lead frame. As a result, a problem easy occurs that terminals or the like of QFN are covered with a resin.

For this reason, a production method, in which a pressure-sensitive adhesive tape is adhered to the back face of a lead frame, and resin leakage to the back face of the lead frame is prevented by a seal effect utilizing self-adhesive force of the pressure-sensitive adhesive tape, is effective to the production method of QFN.
Herein, it is substantially difficult in terms of handling property to adhere a heat-resistant pressure-sensitive adhesive tape to the back face of the lead frame after mounting a semiconductor chip onto the lead frame or after wire bonding. It is therefore desired that a heat-resistant pressure-sensitive adhesive tape is firstly adhered to the back face of the lead frame, and after passing through mounting of a semiconductor chip and wire bonding, encapsulation with an encapsulation resin is conducted and a heat-resistant pressure-sensitive adhesive tape is then peeled. A method of carrying out a series of steps of wire bonding and the like while preventing resin leakage, using a heat-resistant pressure-sensitive adhesive tape having a pressure-sensitive adhesive layer having a thickness of 10 μm or less, has been proposed as an example of such methods (for example, JP-A-2002-184801).

### SUMMARY OF THE INVENTION

In the above-mentioned production methods, in addition to a performance of preventing leakage of an encapsulation resin, the pressure-sensitive adhesive tape is also required to have a high heat resistance sufficient to resist heat in the mounting step of semiconductor chip, not to adversely affect delicate operating properties in a wire bonding step and to have excellent peelability after resin encapsulation.
It is difficult to satisfy all of those requirements. Particularly, in a process of the production of various and diversified QFN in recent years (particularly, the production of MAP type in which a lot of packages are en block encapsulated), there are cases where the pressure-sensitive adhesive tape is influenced by thermal history and certainty of resin leakage prevention of an encapsulation resin by the pressure-sensitive adhesive tape is decreased, and the pressure-sensitive adhesive tape adversely affects certainty of wire bonding.
In the light of the above, there has been demanded a heat-resistant pressure-sensitive adhesive tape which highly prevents resin leakage and does not adversely affect wire bonding even under a severe condition such as a MAP-QFN manufacturing process, and also has excellent peelability after resin encapsulation.

The present invention has been made in view of the above problems.
Accordingly, an object of the present invention is to provide a heat-resistant pressure-sensitive adhesive tape which highly prevents resin leakage and does not adversely affect certainty of wire bonding even under a severe condition such as a MAP-QFN manufacturing process, and also has excellent peelability after resin encapsulation.
Another object of the present invention is to provide a method for producing a semiconductor device, using the pressure-sensitive adhesive tape.

As a result of various investigations on properties, material, thickness and the like of a heat-resistant pressure-sensitive adhesive tape in order to achieve the above objects, the present inventors have found that the above objects can be achieved by using a base material layer in which a glass transition temperature (Tg) is not observed in a specific temperature region, and have reached to complete the present invention.
Namely the present invention provides a pressure-sensitive adhesive tape for resin encapsulation in production of a resin encapsulation type semiconductor device, the pressure-sensitive adhesive tape comprising: a base material layer which does not have a glass transition temperature in a temperature region of 260°C or lower, and a pressure-sensitive adhesive layer laminated on the base material layer.

It is preferable that the base material layer does not have a glass transition temperature in a temperature region of 300°C or lower. It is preferable that the base material layer has a thickness of from 5 to 100 μm.
It is preferable that the base material layer has a degree of heat shrinkage of 0.40% or less when heated at 180°C for 3 hours.
It is preferable that the pressure-sensitive adhesive layer is laminated on only one side of the base material layer.
It is preferable that the pressure-sensitive adhesive layer has a thickness of from 2 μm to 50 μm.
It is preferable that a ratio (B/A) of a thickness of the pressure-sensitive adhesive layer (B) to a thickness of the base material layer (A) is 3 or less.
It is preferable that a pressure-sensitive adhesive constituting the pressure-sensitive adhesive layer has a 5% weight loss temperature of 250°C or higher in accordance with a thermogravimetric analysis under measurement conditions where a temperature rising rate is 10°C/min, an atmosphere gas is air and a gas flow rate is 200 ml/min.
It is preferable that an amount of a gas generated when a pressure-sensitive adhesive constituting the pressure-sensitive adhesive tape is heated at 200°C for 1 hour is 1.0 mg/g or less.
It is preferable that the pressure-sensitive adhesive tape has an adhesive force at a peel angle of 180° to a lead frame of from 0.05 to 6.0 N/19 mm width.
It is preferable that the pressure-sensitive adhesive tape has an adhesive force at a peel angle of 180° to a lead frame when heated at 200°C for 1 hour and then cooled to ordinary temperature of from 0.1 to 6.0 N/19 mm width.
It is preferable that the pressure-sensitive adhesive tape has an adhesive force at a peel angle of 180° to an encapsulation resin of 10.0 N/19 mm width or less.
It is preferable that the pressure-sensitive adhesive layer has a storage modulus at 200°C of 0.50×10⁵ Pa or more.
It is preferable that a pressure-sensitive adhesive constituting the pressure-sensitive adhesive layer is a silicone pressure-sensitive adhesive, an acrylic pressure-sensitive adhesive or a rubber pressure-sensitive adhesive.
It is preferable that a pressure-sensitive adhesive constituting the pressure-sensitive adhesive layer has a gel fraction of 60% or more.
It is preferable that the pressure-sensitive adhesive tape further comprises a release sheet in contact with the pressure-sensitive adhesive layer, the release sheet satisfying at least one of the following requirements (a) to (d):
(a) a peel strength at a peel angle 90°±15° being 1.5 N/50 mm width or less,
(b) a peel strength at a peel angle 120°±15° being 1.2 N/50 mm width or less,
(c) a peel strength at a peel angle 150°±15° being 1.0N/50 mm width or less, and
(d) a peel strength at a peel angle 180°+0° and 180°-15° being 1.0 N/50 mm width or less.

It is preferable that the pressure-sensitive adhesive tape is for use in a method for producing a resin encapsulation type semiconductor device, the method comprising:
adhering a pressure-sensitive adhesive tape to a face of a metal lead frame having a terminal part and a die pad, the face being opposite a face of the metal lead frame on which the die pad is provided;
die-bonding a semiconductor chip having an electrode pad onto the die pad of the metal lead frame;
electrically connecting a tip of the terminal part of the metal lead flame and the electrode pad on the semiconductor chip with a bonding wire; and
encapsulating the face of the metal lead frame on which the semiconductor chip is provided with an encapsulation resin.

In addition, the present invention provides a method for producing a resin encapsulation type semiconductor device, the method comprising:
adhering the above-mentioned pressure-sensitive adhesive tape of the invention to a face of a metal lead frame having a terminal part and a die pad, the face being opposite a face of the metal lead frame on which the die pad is provided;
die-bonding a semiconductor chip having an electrode pad onto the die pad of the metal lead frame;
electrically connecting a tip of the terminal part of the metal lead frame and the electrode pad on the semiconductor chip with a bonding wire; and
encapsulating the face of the metal lead frame on which the semiconductor chip is provided with an encapsulation resin.
In the present specification, unless otherwise indicated, the expression "from X to Y (X and Y each are a numerical value)" showing a numerical range is used to intend to mean that the numerical range includes numerical values of both ends of the expression (i.e., including X and Y).

The pressure-sensitive adhesive tape according to the present invention highly prevents resin leakage and does not affect certainty of wire bonding even under severe conditions such as in MAP-QFN production process, and also has excellent peelability after resin encapsulation.
In addition, in accordance with the method for producing a semiconductor device according to the present invention, even though the method is used in MAP-QFN production process, resin leakage is difficult to occur, certainty of wiring bonding is high, and peeling of a pressure-sensitive adhesive tape for resin encapsulation after resin encapsulation is easy.

### BRIEF DESCRIPTION OF THE DRAWINGS

Figs. 1A to IF represent a process chart showing one example of the production method of a semiconductor device according to the present invention.
Fig. 2A is a planar view showing one example of a lead frame used in the production method of a semiconductor device according to the present invention, and Fig. 2B is an enlarged view of a chief part of the lead frame.

### Description of Reference Numerals and Signs

- 10:: Package pattern region
- 11:: Lead frame
- 11a:: Opening
- 11b:: Lead terminal
- 11c:: Die pad
- 15:: Semiconductor chip
- 16:: Bonding wire
- 17:: Encapsulation resin
- 19:: Conductive paste
- 20:: Pressure-sensitive adhesive tape
- 21:: Semiconductor device

### BEST MODE FOR CARRYING OUT THE INVENTION

### Base material layer

The pressure-sensitive adhesive tape of the present invention includes a base material layer which does not have a glass transition temperature in a temperature region of 260°C or lower.
A pressure-sensitive adhesive tape for resin encapsulation in the production of a resin encapsulation type semiconductor device is exposed to a high temperature when used. Particularly, the pressure-sensitive adhesive tape is generally exposed to a high temperature of about 200°C in a wire bonding step.
The pressure-sensitive adhesive tape of the present invention includes a base material layer which does not have a glass transition temperature in a temperature region of 260°C or lower. Consequently, the pressure-sensitive adhesive tape highly prevents resin leakage and does not affect certainty of wire bonding even under severe conditions as in MAP-QFN production process, and also has excellent peelability after resin encapsulation.
According to the investigations by the present inventors, unexpectedly, even in the case that the base material layer does not have a glass transition temperature at about 200°C which is the above-mentioned wire bonding temperature, there were some cases where resin leakage occurs in a resin encapsulation step and the pressure-sensitive adhesive sheet which has received an influence by thermal history affects certainty of wire bonding.
More preferably, the base material layer does not have a glass transition temperature in a temperature region of 300°C or lower.

The base material layer is not particularly limited so long as it does not have a glass transition temperature in the above-described temperature region, and it is possible to use any base material layer so long as it is constituted of a material used for a base material layer of a pressure-sensitive adhesive tape used in the art of this field.
Examples of such material include a polyether sulfone (PES) resin, a polyether imide (PEI) resin, a polysulfone (PSF) resin, a polyether ether ketone (PEEK) resin, a polyalylate (PAR) resin, an aramide resin, a polyimide resin, a liquid crystal polymer (LCP), and metal foils such as aluminum foil.
Of those, a polyimide resin is preferably used from the standpoints of heat resistance and base material strength.
In the present specification, the term "glass transition temperature" means a temperature showing a peak of loss tangent (tan δ) confirmed under the conditions of temperature rising rate: 5°C/min, sample width: 5 mm, chuck distance: 20 mm and frequency: 10 Hz in DMA method (tensile method). The glass transition temperature is measured with a commercially available equipment (for example, RSA-II, manufactured by Rheometric Scientific FE Ltd.). Therefore, for example, the expression "does not have a glass transition temperature in a temperature region of 260°C or lower" means that the peak of loss tangent (tan δ) is not observed in a temperature region of 260°C or lower.

The base material layer has a thickness of preferably 5 μm or more, and more preferably 10 μm or more, from the standpoint of handling properties of a pressure-sensitive adhesive tape (for example, bending or tearing of a tape is difficult to occur). On the other hand, the base material layer has a thickness of preferably 100 μm or less, and more preferably 75 μm or less, from the standpoint of peelability of the pressure-sensitive adhesive tape.

The base material layer preferably has a degree of heat shrinkage after heating at 180°C for 3 hours of 0.40% or less, from the standpoint of prevention of warpage of a lead frame due to shrinkage of the base material layer.
In the present specification, the term "degree of heat shrinkage" is measured as follows. Namely, a 5 cm square film is heated at 180°C for 3 hours and the proportion (%) of dimensional change with respect to the size (5 cm square) before heating (100%)is taken as the "degree of heat shrinkage". The degree of shrinkage is measured by the commercially available projector (PJ-H3000F, manufactured by Mitsutoyo Corporation).

### Pressure-sensitive adhesive

The pressure-sensitive adhesive tape has a pressure-sensitive adhesive layer laminated on the base material layer. Herein, the pressure-sensitive adhesive layer may be provided on only one side of the base material layer and may be provided on both sides of the base material layer.
The pressure-sensitive adhesive layer is preferably laminated on only one side of the base material layer.

The pressure-sensitive adhesive constituting the pressure-sensitive adhesive layer is not particularly limited so long as it has heat resistance, and may be any type of pressure-sensitive type, heat-sensitive type and light-sensitive type.
Examples of the pressure-sensitive adhesive include various pressure-sensitive adhesives such as acrylic pressure-sensitive adhesive, silicone pressure-sensitive adhesive, rubber pressure-sensitive adhesive and epoxy pressure-sensitive adhesive. Of those, from the standpoint of heat resistance, silicone pressure-sensitive adhesive and acrylic pressure-sensitive adhesive are preferably used, and silicone pressure-sensitive adhesive is more preferably used.
Examples of the silicone pressure-sensitive adhesive include a pressure-sensitive adhesive containing dimethylpolysiloxane.
Examples of the acrylic pressure-sensitive adhesive include a pressure-sensitive adhesive including an acrylic copolymer obtained by copolymerization of monomers containing at least alkyl (meth)acrylate. In the present specification, the term "alkyl (meth)acrylate" means alkyl acrylate and/or alkyl methacrylate.
Examples of the alkyl (meth)acrylate include methyl (meth)acrylate, ethyl (meth)acrylate, butyl (meth)acrylate, isoamyl (meth)acrylate, n-hexyl (meth)acrylate, 2-ethylhexyl (meth)acrylate, isooctyl (meth)acrylate, isononyl (meth)acrylate, decyl (meth)acrylate and dodecyl (meth)acrylate. Above all, a copolymer of an acrylic acid monomer and a 2-ethylhexyl (meth)acrylate monomer, and a copolymer of methyl (meth)acrylate and/or ethyl (meth)acrylate, an acrylic acid monomer and a 2-ethylhexyl (meth)acrylate monomer are preferred.

The pressure-sensitive adhesive layer may contain a crosslinking agent, if necessary.
Examples of the crosslinking agent include an isocyanate crosslinking agent, an epoxy crosslinking agent, an aziridine compound and a chelate crosslinking agent.
The amount of the crosslinking agent added is not particularly limited. For example, in the case of using an acrylic pressure-sensitive adhesive, the amount of the crosslinking agent added is preferably from 0.1 to 15 parts by weight, and more preferably from 0.5 to 10 parts by weight, per 100 parts by weight of the acrylic pressure-sensitive adhesive. When the crosslinking agent is used in this range, viscoelasticity of the pressure-sensitive adhesive layer can appropriately be set, and appropriate adhesive force of the pressure-sensitive adhesive layer to a lead frame or an encapsulation resin can be obtained. As a result, the phenomena that an encapsulation resin is peeled or broken and a part of the pressure-sensitive adhesive layer adheres to a lead frame or an encapsulation resin (that is, adhesive residue) are prevented even when peeling the pressure-sensitive adhesive tape. Additionally, excess curing of the pressure-sensitive adhesive layer can be suppressed.

The pressure-sensitive adhesive constituting the pressure-sensitive adhesive layer preferably has a gel fraction of 60% or more from the standpoint of prevention of adhesive residue when peeling the pressure-sensitive tape of the present invention.
Prevention of adhesive residue makes it possible to omit a cleaning step of a semiconductor chip.
The gel fraction of the pressure-sensitive adhesive can be adjusted by, for example, adjusting a degree of crosslinking.
In the present specification, the term "gel fraction" means a proportion of a solvent-insoluble component in a pressure-sensitive adhesive, and is measured and calculated by the following method.

### (Measurement method of gel fraction)

A pressure-sensitive adhesive is applied to a surface of a release sheet or the like, followed by drying and curing. About 0.1 g of the pressure-sensitive adhesive film thus obtained is covered with a tetrafluoroethylene sheet, and dipped in an excess amount of a solvent (toluene) at room temperature for 1 week. Weights of the pressure-sensitive adhesive layer before and after the dipping are measured, and the ratio (weight after dipping/weight before dipping)× 100 is used as a gel fraction.

The pressure-sensitive adhesive layer may further contain various additives generally used in the art of this field, such as a plasticizer, a pigment, a dye, an age inhibitor, and antistatic agent, and a filler added for the improvement of properties (for example, elastic modulus) of the pressure-sensitive adhesive layer. The amount of the additives added is not particularly limited so long as the amount does not impair appropriate adhesiveness of the pressure-sensitive adhesive layer. The amount of the additives added is generally from 0.5 to 20 parts by weight, and preferably from 1.0 to 15 parts by weight, per 100 parts by weight of the whole pressure-sensitive adhesive layer.

The amount of a gas generated when heating the pressure-sensitive adhesive layer at 200°C for 1 hour is desirably 1.0 mg/g or less from the standpoint of preventing poor wire bonding due to secondary deposition of the generated gas components on the surface of a lead frame and decrease in moisture resistance reliability of a package after resin encapsulation.
The amount of a gas generated can be lowered by, for example, increasing the degree of crosslinking of the pressure-sensitive adhesive, and removing low molecular weight components in the pressure-sensitive adhesive.
In the present specification, the term "the amount of a gas generated" means an amount of a gas generated (total outgas amount, μg (gas)/g (pressure-sensitive adhesive layer)) obtained by collecting 10 mg of a pressure-sensitive adhesive layer, encapsulating in a vial for gas chromatography, trapping a gas generated by heating, and measuring the amount of the gas generated with gas chromatograpy.
The amount of a gas generated can be measured by, for example, the following apparatus and conditions.

### <Measuring apparatus>

Head space autosampler: "7694", manufactured by Aglilent Tchnologies
GC: "6890 Plus", manufactured by Agilent Technologies
MS: "5973N", manufactured by Agilent Technologies

### <Measurement conditions>

### (Head space autosampler)

Pressure time: 0.12 min
Loop priority time: 0.12 min
Loop equilibrium time: 0.05 min
Injection time: 3.00 min
Sample loop temperature: 200°C
Transfer line temperature: 220°C

### (GC)

Column: HP-5MS (0.25 μm), 0.25 mm diameter × 30 m Carrier gas: He, 1.0 ml/min (constant flow mode)
Column head pressure: 48.7 kPa (40°C)
Inlet: split (split ratio 46:1)
Inlet temperature: 250°C Column temperature: 40°C (holding for 5 min) - (+10°C/min) → 300°C (holding for 9 min)

### (MS)

Ionization method: EI
Emission current: 35 μA
Electron energy: 70 eV
E.M. voltage: 1141V
Source temperature: 230°C
Q-pole: 150°C
Interface: 280°C

The pressure-sensitive adhesive desirably has a 5% weight loss temperature of 250°C or higher, from the standpoint of prevention of adhesive residue after peeling a tape due to deterioration of a pressure-sensitive adhesive by a heating step during semiconductor production step such as die attach or wire bonding.
The 5% weight loss temperature can be increased by, for example, increasing a degree of crosslinking of a pressure-sensitive adhesive and removing low molecular weight components in the pressure-sensitive adhesive.
The 5% weight loss temperature is measured under the conditions of temperature rising rate: 10°C/min, atmosphere gas: air, and gas flow rate: 200 ml/min.
Specifically, the 5% weight loss temperature is measured by the following measurement method.

### (Measurement method)

Measurement item: TG (thermogravity)
Measuring apparatus: "TG/DTA 6200", manufactured by SII NanoTechnology Inc.
Measurement operation: A sample is placed in a platinum container, TG measurement is conducted under the following conditions, and a value at the time of 5% weigh loss is measured.
Measurement conditions:
Measurement temperature region: Room temperature to 850°C
Temperature rising rate: 10°C/min
Atmosphere gas: Air
Gas flow rate: 200 ml/min

The pressure-sensitive adhesive tape is sometimes adhered to a lead frame before a wire connecting step of electrically connecting a tip of a terminal part of a lead frame with an electrode pad on the semiconductor chip by a bonding wire. In such a case, where the pressure-sensitive adhesive layer is soft, sufficient wire bondability is not obtained. Therefore, the pressure-sensitive adhesive layer preferably has a storage modulus at 200°C of 5.0×10⁴ Pa or more from the standpoint of sufficient wire bondability.
On the other hand, from the standpoint of obtaining appropriate adhesive force, the storage modulus is 1.0×10⁷ Pa or less.
In the present specification, the term "storage modulus" is a value obtained by preparing a sample layer in a thickness of from 1.5 mm to 2 mm, punching the sample layer with a punch having a diameter of 7.9 mm to obtain a sample, and measuring the sample with a viscoelastic spectrometer (ARES) manufactured by Rheometric Scientific under the conditions of chuck pressure: 100 g weight, and frequency: 1 Hz.

The pressure-sensitive adhesive layer has a thickness of preferably 2 μm or more, more preferably 3 μm or more, and further preferably 4 μm or more, from the standpoint of sufficient adhesive force to a lead frame. On the other hand, from the standpoint of sufficient wire bondability, the thickness is preferably 50 μm or less, more preferably 40 μm or less, and further preferably 30 μm or less.
A ratio (B/A) of the thickness of the pressure-sensitive adhesive layer (B) to the thickness of the base material layer (A), in the pressure-sensitive adhesive tape is preferably 3 or less from the standpoint of suppression of adhesive residue when peeling the tape.

### Production method of pressure-sensitive adhesive tape

The pressure-sensitive adhesive tape of the present invention can be prepared by the conventional production methods in the art of this field. For example, the above-described pressure-sensitive adhesive layer components are prepared, and applied to one side of the base material layer, followed by drying. Thus, a pressure-sensitive adhesive layer can be formed. As the coating method of the pressure-sensitive adhesive layer components, various methods such as bar coater coating, air knife coating, gravure coating, gravure reverse coating, reverse roll coating, lip coating, die coating, dip coating, offset printing, flexo printing and screen printing can be applied. A method of separately forming a pressure-sensitive adhesive layer on a release liner and adhering the pressure-sensitive adhesive layer to a base material film may also be used.

### Pressure-sensitive adhesive Tape

The pressure-sensitive adhesive tape of the present invention thus obtained is adhered to a lead frame in the production of a resin encapsulation type semiconductor device, and therefore is required to have appropriate pressure-sensitive adhesiveness to a lead frame.
The pressure-sensitive adhesive tape has an adhesive force at a peel angle of 180° to a lead frame (particularly, a leas frame formed by a metal plate described hereinafter) is preferably 0.05 N/19 mm width or more, more preferably 0.10 N/19 mm width or more, and further preferably 0.15 N/19 mm width or more, from the standpoint of sufficient adhesive force (for example, adhesive force such that peeling of a tape does not occurs during a process) to a lead frame. On the other hand, the pressure-sensitive adhesive tape has an adhesive force of preferably 6.0 N/19 mm width or less, more preferably 3.0 N/19 mm width or less, and further preferably 4.0 N/19 mm or less, from the standpoint of prevention of adhesive residue and deformation of a die pad part or the like that might occur at the time of peeling the tape when failed to adhere the tape to the lead frame.
The peel strength is measured by a commercially available measuring equipment (for example, Autograph AG-X, manufactured by Shimadzu Corporation).

Similarly, the pressure-sensitive adhesive tape has an adhesive force at a peel angle of 180° to an encapsulation resin (particularly, an encapsulation resin described hereinafter) of 10.0 N/19 mm width or less, preferably 8.0 N/19 mm width or less, and more preferably 6.0 N/19 mm or less, from the standpoint of prevention of adhesive residue on the encapsulation resin when peeling the tape.

The pressure-sensitive adhesive tape of the present invention is peeled from a lead frame at an optional stage after a resin encapsulation step. Therefore, the pressure-sensitive adhesive tape is required to have adhesive force to a lead frame even after exposed to high temperature, from the standpoint of prevention of resin leakage. However, the pressure-sensitive adhesive tape having too strong adhesive force easily causes adhesive residue, and is difficult to be peeled. Additionally, as the case may be, there is a concern that such a pressure-sensitive adhesive tape leads to peeling and breakage of a molded resin due to stress for peeling the pressure-sensitive adhesive tape. From those standpoints, adhesion stronger than adhesive force which suppresses protrusion of an encapsulation resin is rather not preferable. For this reason, the pressure-sensitive adhesive tape has a peel strength (adhesive force) at a peel angle of 180° to a lead frame (particularly, a lead frame formed by a metal plate described hereinafter) after heating at 200°C for 1 hour of preferably 0.1 N/19 mm width or more, more preferably 0.2 N/19 mm width or more, and further preferably 0.3 N/19 mm width or more, and on the other hand, it is preferably 6.0 N/19 mm width or less, more preferably 5.0 N/19 mm width or less, and further preferably 4.0 N/19 mm width or less.
In the present specification, the "peel strength (adhesive force)" is measured according to JIS Z0237: 1999.

On the other hand, the pressure-sensitive adhesive tape is firstly adhered to a lead frame, and then peeled from the lead frame at optional stage. Where the pressure-sensitive adhesive tape has too strong adhesive force, the pressure-sensitive adhesive tape is difficult to be peeled, and as the case may be, leads to peeling and breakage of a molded resin due to stress for peeling the pressure-sensitive adhesive tape. Therefore, adhesion stronger than adhesive force which suppresses protrusion of an encapsulation resin is rather not preferable. For example, it is suitable in the production process of a semiconductor device that the adhesive force at 25°C according to JIS Z0237 is from about 0.05 to 6.0 N/19 mm width. Furthermore, the adhesive force to a lead frame after heating the pressure-sensitive adhesive tape at 200°C for 1 hour is preferably from about 0.1 to 6.0 N/19 mm width, and more preferably from about 0.1 to 4.0 N/19 mm width.

It is preferable that the pressure-sensitive adhesive tape of the present invention further includes a release sheet. The release sheet is a sheet formed in contact with the pressure-sensitive adhesive layer in order to protect the pressure-sensitive adhesive layer. The release sheet preferably has a specific value of peel strength, depending on the kind and the like of the pressure-sensitive adhesive contained in the pressure-sensitive adhesive layer. The peel strength can appropriately be adjusted by an angle when peeling the pressure-sensitive adhesive tape. For example, the peel length satisfying at least one of the following requirements (a) to (d) is preferred, and the peel strength satisfying more requirements is more preferred.
(a) The peel strength at a peel angle of 90°±15° is 1.5 N/50 mm width or less, preferably 1.0 N/50 mm width or less, more preferably 0.5 N/50 mm with or less, further preferably 0.3 N/50 mm width or less, and still more preferably 0.2 N/50 mm width or less.
(b) The peel strength at a peel angle of 120°±15° is 1.2 N/50 mm width or less, preferably 1.0 N/50 mm width or less, more preferably 0.8 N/50 mm with or less, further preferably 0.6 N/50 mm width or less, and still more preferably 0.3 N/50 mm width or less.
(c) The peel strength at a peel angle of 150°±15° is 1.0 N/50 mm width or less, preferably 0.8 N/50 mm width or less, more preferably 0.6 N/50 mm with or less, further preferably 0.5 N/50 mm width or less, still more preferably 0.3 N/50 mm width or less, and particularly preferably 0.2 N/50 mm width or less.
(d) The peel strength at a peel angle of 180°+0° and 180°-15° is 1.0 N/50 mm width or less, preferably 0.8 N/50 mm width or less, more preferably 0.6 N/50 mm with or less, further preferably 0.5 N/50 mm width or less, still more preferably 0.3 N/50 mm width or less, and particularly preferably 0.2 N/50 mm width or less.

When the peel strength is fallen in the above-mentioned range, even in the case of using a tape laminating apparatus or the like generally utilized, excess peel strength for peeling a release sheet is not required, wrinkles of a pressure-sensitive tape and deviation of adhering position do not occur, and residual stress can be prevented from being applied to the pressure-sensitive adhesive tape. Accordingly, occurrence of warpage of a lead frame, resin leakage of an encapsulation resin, and the like can be suppressed.

The release sheet includes release substrates formed in a single layer structure or a multilayer structure and employing materials generally used in the art of this field, for example, polymers such as polyvinyl chloride, polyvinylidene chloride, polyester (such as polyethylene terephthalate), polyimide, polyether ether ketone, polyolefin (such as low density polyethylene, linear polyethylene, middle density polyethylene, high density polyethylene, ultra-low density polyethylene, random copolymerized polypropylene, block copolymerized polypropylene, homopolypropylene, polybutene and polymethylpentene), polyurethane, ethylene-vinyl acetate copolymer, ionomer resin, ethylene-(meth)acrylic acid copolymer, ethylene-(meth)acrylic acid ester (random or alternate) copolymer), ethylene-butene copolymer, ethylene-hexene copolymer, fluorine resin, cellulose resin, and crosslinked products of those.

As the release sheet, it is suitable to use a release sheet in which at least one face thereof that comes in contact with the pressure-sensitive adhesive layer is subjected to a release treatment so that the release sheet does not substantially adhere to the pressure-sensitive adhesive layer. The release treatment can be conducted using the conventional methods and materials in the art of this field. Examples of the release treatment include a release treatment with a silicon resin and a release treatment with a fluorine resin. Specifically, light peel grade and middle peel grade of CERAPEEL series (Toray Advanced Film Co., Ltd.) are exemplified.

### Production method of resin encapsulation type semiconductor device

The pressure-sensitive adhesive tape of the present invention is a pressure-sensitive adhesive tape for use in the production of a semiconductor device, specifically when conducting resin encapsulation. That is, the pressure-sensitive adhesive tape is used to adhere to at least one face, generally the back face (face opposite the face on which a semiconductor chip is mounted, hereinafter the same), of a lead frame when conducting resin encapsulation of a semiconductor chip mounted on the front face of the lead frame, and to peel after encapsulation.
For example, the pressure-sensitive adhesive tape of the present invention is for use in a method for producing a semiconductor device, including steps of adhering the pressure-sensitive adhesive tape to at least a face, generally the back face, of a lead frame, mounting a semiconductor chip on the surface of the die pad, encapsulating the semiconductor chip side with a resin, and peeling the pressure-sensitive adhesive tape after encapsulation.

A method for producing a resin encapsulation type semiconductor chip using the pressure-sensitive adhesive tape of the present invention is described below.
The method for producing a resin encapsulation type semiconductor chip generally includes the following steps.
Step 1: adhering a pressure-sensitive adhesive tape (heat-resistant pressure-sensitive adhesive tape) to a face of a metal lead frame having a terminal part and a die pad, said face being opposite a face of the metal lead frame on which the die pad is provided.
Step 2: die-bonding a semiconductor chip having an electrode pad onto the die pad of the metal lead frame.
Step 3: electrically connecting the tip of the terminal part of the metal lead frame and the electrode pad on the semiconductor chip with a bonding wire.
Step 4: encapsulating the face of the metal lead frame on which the semiconductor chip is provided with an encapsulation resin.
The steps 2 to 4 are conducted in this order, but it is sufficient that the step 1 is conducted before the step 4. That is, the step I may be conducted before or after the step 2 (that is, before the step 3), or after the step 3.
Preferably, the steps 1 to 4 are conducted in this order.
As described before, the pressure-sensitive adhesive tape of the present invention adhered to the lead frame in the step I is peeled from the lead frame at an optional stage after step 4.

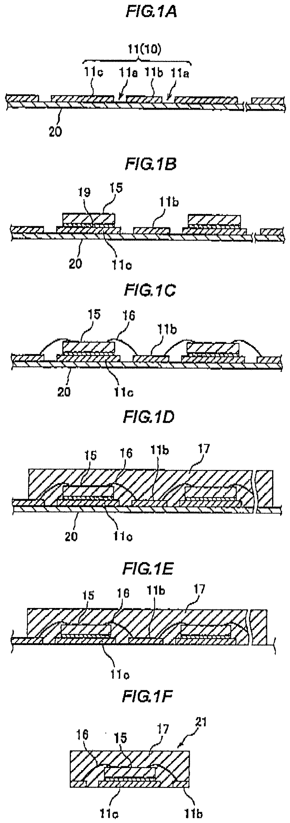

Specifically, as shown in Fig. 1A, a pressure-sensitive adhesive tape 20 of the present invention is adhered to one face, that is, the back face, of a lead frame 11.
The lead frame 11 is generally formed by a metal plate such as Cu-based material (such as Cu-Fe-P) or Fe-based material (such as Fe-Ni). Particularly, a lead frame in which an electrical contact part (connection part to a semiconductor chip, which will be described hereinafter) is covered (plated) with silver, nickel, palladium, gold or the like is preferred. The lead frame 11 generally has a thickness of from about 100 to 300 μm.

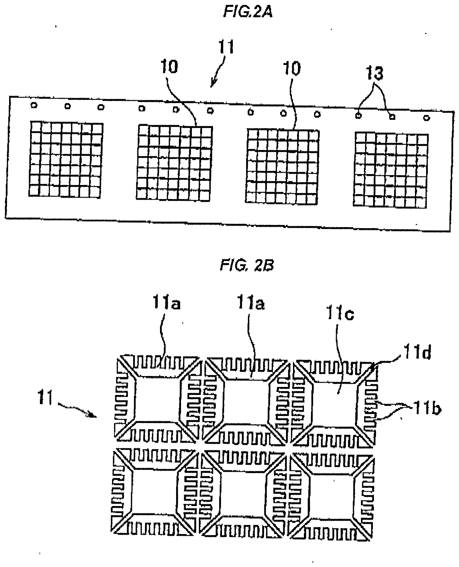

The lead frame 11 is preferably one in which plural given configuration patterns (for example, configuration pattern of individual QFN) are arranged, so that it can be easily divided at the subsequent cutting step. Specifically, as shown in Figs. 2A and 2B, the configuration where package pattern regions 10 are arranged in a matrix shape on the lead frame 11 is called QFN, MAP-QFN or the like, and is one of the most preferred configurations.

The lead frame 11 generally has a die pad 11 and a lead terminal 11b. The die pad 11c and the lead terminal 11b may be provided separately. However, as shown in Fig. 2B, the lead frame 11 integrally provided with the plural lead terminals 11b defined by plural adjacent openings 11a, the die pads 11c arranged at the center of the openings 11a, and die bars 11d which optionally support the die pads 11c at four corners of the opening 11a is preferred. The die pad 11c and the lead terminal 11b may be formed for the purpose of other function such as heat release.

Adhesion of the pressure-sensitive adhesive tape 20 to the lead frame 11 is preferably conducted to at least a package pattern region 10 in the lead frame 11, a region outer than the package pattern region 10 of the lead frame, that is, a region including the entire outer periphery of a resin encapsulation region to be resin-encapsulated, or the package pattern region 10 and a region including the entire outer periphery of the package pattern region.
In the case that the pressure-sensitive adhesive tape of the present invention is adhered to a region including the entire outer periphery of the resin encapsulation region, the pressure-sensitive adhesive tape may be adhered to not only the back face of the lead frame, but the front face thereof. In the case that the pressure-sensitive adhesive tape is adhered to the package pattern region 10 and the region including the entire outer periphery of the resin encapsulation region to be resin-encapsulated, the pressure-sensitive adhesive tape is preferably adhered to only the back face of the lead frame.

The lead frame 11 generally has, in the vicinity of edge side thereof, a hole for a guide pin (for example, 13 in Fig. 2A) for conducting positioning at the resin encapsulation. Therefore, the pressure-sensitive adhesive tape is preferably adhered to an area which does not clog the hole. The plural package pattern regions 10 are arranged in a longitudinal direction of the lead frame 11. Therefore, the pressure-sensitive adhesive tape 20 is preferably adhered continuously so as to cross over those plural regions.

A semiconductor chip 15 is mounted on the surface of the lead frame 11 (face to which a pressure-sensitive adhesive tape 20 is not adhered), as shown in Fig. 1B.
Generally, the lead frame 11 is provided with a fixation area called a die pad 11c for fixing the semiconductor chip 15, as described above. Therefore, the semiconductor chip is mounted on the die pad 11c.
Various methods using, for example, a conductive paste 19, an adhesive tape or a pressure-sensitive adhesive (for example, thermosetting pressure-sensitive adhesive) are used to mount the semiconductor chip 15 on the die pad 11c. In the case of mounting using a conductive paste, a pressure-sensitive adhesive or the like, heat-curing is generally conducted at a temperature of from about 150 to 200°C for about 30 to 90 minutes.

An electrode pad (not shown) on the surface of the semiconductor chip 15 and the lead frame 11 are optionally wire-bonded as shown in Fig. 1C.
The wire bonding is conducted with a bonding wire 16, for example, a gold wire or aluminum wire. The wire bonding is generally conducted by the combination of vibration energy by ultrasonic wave and press-bonding energy by application of pressure in a state of being heated at 150 to 250°C.

Next, the lead frame 11 is sandwiched between upper and lower molds (not shown), and an encapsulation resin 17 is injected to encapsulate the semiconductor chip 15. The encapsulation in this case may be either of one-side encapsulation and double-side encapsulation in the case where the pressure-sensitive adhesive tape is adhered to the front face and back face of the lead frame in the region including the entire outer periphery of the resin encapsulation region in the lead frame. In the case where the pressure-sensitive adhesive tape is adhered to the package pattern region 10 and the region including the entire outer periphery of the package pattern region 10, one-side encapsulation is preferably conducted. Above all, in the case of conducting the one-side encapsulation, the pressure-sensitive adhesive tape of the present invention can preferably be used.
Encapsulation of the semiconductor chip is conducted to protect the semiconductor chip 15 mounted on the lead frame 11 and the bonding wire 16. For example, a method of molding in a mold using an epoxy resin or the like is a representative method. In this case, it is preferred that plural semiconductor chips are simultaneously encapsulated using a mold including an upper mold and a lower mold having plural cavities. Generally, the heating temperature at the resin encapsulation is from about 170 to 180°C, and curing is conducted at this temperature for several minutes, and post-mold curing is then conducted for several hours.
Thereafter, the lead frame 11 including the encapsulation resin 17 is taken out of the mold, as shown in Fig. 1D.

The pressure-sensitive adhesive tape adhered to the back face of the lead frame 11 is peeled, as shown in Fig. 1E.
The peeling of the pressure-sensitive adhesive tape 20 after encapsulation is preferably carried out before the above-described post-mold curing.

Thereafter, the lead frame 11 containing the encapsulation resin 17 is divided per each semiconductor chip 15, thereby a semiconductor device 21 can be obtained, as shown in Fig. IF.
Dividing the lead frame per each semiconductor chip 15 can be performed using a rotary cutting blade of a dicer or the like.

Incidentally, it is sufficient that the pressure-sensitive adhesive tape of the present invention is adhered to one face, preferably the back face, of the lead frame in resin encapsulation of the semiconductor chip. In the steps shown in Fig. 1A to Fig. 1C, the pressure-sensitive adhesive tape may be adhered after mounting the semiconductor chip, and may be adhered after wire-bonding the semiconductor chip. Above all, the steps are preferably carried out in the order shown by Fig. 1A to Fig. 1C described above. Furthermore, wire bonding may not be conducted depending on the structure of the semiconductor chip.

### Examples

The present invention is described in more detail by reference to Examples and the like, but the invention is not construed as being limited to the Examples.

### Example 1

A 25 µm thick polyimide film (KAPTON 100H (trade name), manufactured by Du pont-Toray Co., Ltd., coefficient of linear thermal expansion: 2.7×10⁻⁵/K, Tg: 402°C) was used as a base material layer. 100 parts by weight of a silicone pressure-sensitive adhesive "SD-4586", manufactured by Dow Corning Toray Silicone Co., Ltd., and 2.5 parts by weight of a platinum catalyst were added to toluene and uniformly dispersed in toluene. The resulting dispersion was applied to one side of the base material layer, followed by drying. Thus, a heat-resistant pressure-sensitive adhesive tape having about 6 µm thick pressure-sensitive adhesive layer was prepared. The pressure-sensitive adhesive had storage modulus at 200°C of 4.0×10⁵ Pa. The tape had adhesive force at peel angle of 180° to a copper lead frame of 1.0 N/19 mm width, and adhesive force at peel angle of 180° to a copper lead frame after heating at 200°C for 1 hour of about 2.7 N/19 mm width. Furthermore, the tape had adhesive force at peel angle of 180° to an encapsulation resin after resin encapsulation of 3.0 N/19 mm.
The copper lead frame used had a surface roughness of about 80 nm. The surface roughness was measured by a contact method using the following measuring equipment and measurement conditions.

### (Measuring equipment)

KLA-Tencor Corporation "P-15"

### (Measurement conditions)

Measurement width: 2 mm
Measurement speed: 50 µm/sec
The pressure-sensitive adhesive had 5% weight loss temperature of 330°C, and the amount of a gas generated after heating the pressure-sensitive adhesive at 200°C for I hour was 0.03 mg/g. Furthermore, the degree of heat shrinkage of the base material layer after heating at 180°C for 3 hours was 0.35%.

### Example 2

A pressure-sensitive adhesive tape was obtained in the same manner as in Example 1, except that a 25 µm thick polyimide film (trade name: APICAL 25NPI (trade name), manufactured by Kaneka Corporation, coefficient of linear thermal expansion: 1.7×10⁻⁵/K, Tg: 421°C) was used as the base material layer. The tape had adhesive force at peel angle of 180° to a copper lead frame of 1.1 N/19 mm width, and adhesive force at peel angle of 180° to a copper lead frame after heating at 200°C for 1 hour of about 2.8 N/19 mm width. Furthermore, the tape had adhesive force at peel angle of 180° to an encapsulation resin after resin encapsulation of 3.2 N/19 mm.
The pressure-sensitive adhesive had 5% weight loss temperature of 330°C, and the amount of a gas generated after heating the pressure-sensitive adhesive at 200°C for 1 hour was 0.03 mg/g. Furthermore, the degree of heat shrinkage of the base material layer after heating at 180°C for 3 hours was 0.11%.

### Example 3

A pressure-sensitive adhesive tape was obtained in the same manner as in Example 1, except that a 50 µm thick polyimide film (KAPTON 200H (trade name), manufactured by Du pont-Toray Co., Ltd., coefficient of linear thermal expansion: 2.7×10⁻⁵/K, Tg: 402°C) was used as a base material layer. The tape had adhesive force at peel angle of 180° to a copper lead frame of 1.3 N/19 mm width, and adhesive force at peel angle of 180° to a copper lead frame after heating at 200°C for 1 hour of about 3.5 N/19 mm width. Furthermore, the tape had adhesive force at peel angle of 180° to an encapsulation resin after resin encapsulation of 3.7 N/19 mm.
The pressure-sensitive adhesive had 5% weight loss temperature of 330°C, and the amount of a gas generated after heating the pressure-sensitive adhesive at 200°C for 1 hour was 0.03 mg/g. Furthermore, the degree of heat shrinkage of the base material layer after heating at 180°C for 3 hours was 0.36%.

### Example 4

A pressure-sensitive adhesive tape was obtained in the same manner as in Example 1, except that the thickness of the pressure-sensitive adhesive layer was changed to 15 µm. The tape had adhesive force at peel angle of 180° to a copper lead frame of 1.8 N/19 mm width, and adhesive force at peel angle of 180° to a copper lead frame after heating at 200°C for 1 hour of about 4.2 N/19 mm width. Furthermore, the tape had adhesive force at peel angle of 180° to an encapsulation resin after resin encapsulation of 4.5 N/19 mm.
The pressure-sensitive adhesive had 5% weight loss temperature of 330°C, and the amount of a gas generated after heating the pressure-sensitive adhesive at 200°C for 1 hour was 0.08 mg/g. Furthermore, the degree of heat shrinkage of the base material layer after heating at 180°C for 3 hours was 0.35%.

### Example 5

A heat-resistant pressure-sensitive adhesive tape was prepared in the same manner as in Example 1, except that a material obtained by adding 5 parts by weight of an isocyanate crosslinking agent as a crosslinking agent to a polymer obtained by copolymerizing 100 parts by weight of butyl acrylate and 10 parts by weight of acrylic acid was used as the pressure-sensitive adhesive. The tape had storage modulus at 200°C of 1.0×10⁶ Pa. The tape had adhesive force at peel angle of 180° to a copper lead frame of 0.5 N/19 mm width, and adhesive force at peel angle of 180° to a copper lead frame after heating at 200°C for 1 hour of about 1.5 N/19 mm width. Furthermore, the tape had adhesive force at peel angle of 180° to an encapsulation resin after resin encapsulation of 4.0 N/19 mm.
The pressure-sensitive adhesive had 5% weight loss temperature of 270°C, and the amount of a gas generated after heating the pressure-sensitive adhesive at 200°C for 1 hour was 0.5 mg/g. Furthermore, the degree of heat shrinkage of the base material layer after heating at 180°C for 3 hours was 0.35%.

### Comparative Example 1

A pressure-sensitive adhesive tape was obtained in the same manner as in Example 1, except that a 25 µm thick polyethylene terephthalate film (TEONX Q81 (trade name), manufactured by Teijin DuPont-Teijin Japan Limited, coefficient of linear thermal expansion: 1.0×10⁻⁵/K, Tg: 156°C) was used as the base material layer. The tape had adhesive force at peel angle of 180° to a copper lead frame of 0.9 N/19 mm width, and adhesive force at peel angle of 180° to a copper lead frame after heating the pressure-sensitive adhesive at 200°C for 1 hour of about 2.5 N/19 mm width. Furthermore, the tape had adhesive force at peel angle of 180° to an encapsulation resin after resin encapsulation of 2.8 N/19 mm.
The pressure-sensitive adhesive had 5% weight loss temperature of 270°C, and the amount of a gas generated after heating the pressure-sensitive adhesive at 200°C for 1 hour was 0.03 mg/g. Furthermore, the degree of heat shrinkage of the base material layer after heating at 180°C for 3 hours was 0.42%.

### Comparative Example 2

A pressure-sensitive adhesive tape was obtained in the same manner as in Example 1, except that a 25 µm thick polyphenyl sulfide film (TORELINA 3030 (trade name), manufactured by Toray Industries, Inc., coefficient of linear thermal expansion: 3.2×10⁻⁵/K, Tg: 127°C) was used as the base material layer. The tape had adhesive force at peel angle of 180° to a copper lead frame of 0,9 N/19 mm width, and adhesive force at peel angle of 180° to a copper lead frame after heating at 200°C for 1 hour of about 2.5 N/19 mm width. Furthermore, the tape had adhesive force at peel angle of 180° to an encapsulation resin after resin encapsulation of 2.9 N/19 mm.
The pressure-sensitive adhesive had 5% weight loss temperature of 270°C, and the amount of a gas generated after heating the pressure-sensitive adhesive at 200°C for 1 hour was 0.03 mg/g. Furthermore, the degree of heat shrinkage of the base material layer after heating at 180°C for 3 hours was 1.9%.

### Example 6

A pressure-sensitive adhesive tape was obtained in the same manner as in Example 1, except that a 12.5 µm thick polyimide film (KAPTON 50H (trade name), manufactured by Du pont-Toray Co., Ltd., coefficient of linear thermal expansion: 2.7×10⁻⁵/K, Tg: 404°C) was used as the base material layer and the thickness of the pressure-sensitive adhesive layer was changed to 40 µm, The tape had adhesive force at peel angle of 180° to a copper lead frame of 3.8 N/19 mm width, and adhesive force at peel angle of 180° to a copper lead frame after heating at 200°C for 1 hour of about 5.5 N/19 mm width. Furthermore, the tape had adhesive force at peel angle of 180° to an encapsulation resin after resin encapsulation of 6.5 N/19 mm.
The pressure-sensitive adhesive had 5% weight loss temperature of 330°C, and the amount of a gas generated after heating the pressure-sensitive adhesive at 200°C for 1 hour was 0.32 mg/g. Furthermore, the degree of heat shrinkage of the base material layer after heating at 180°C for 3 hours was 0.35%.

### Example 7

A pressure-sensitive adhesive tape was obtained in the same manner as in Example 1, except that a material obtained by adding 2 parts by weight of a platinum catalyst to 100 parts by weight of a silicone pressure-sensitive adhesive "SD-4560", manufactured by Dow Corning Toray Silicone Co., Ltd., was used as the pressure-sensitive adhesive. The pressure-sensitive adhesive had storage modulus at 200°C of 8.0×10³ Pa. The tape had adhesive force at peel angle of 180° to a copper lead frame of 1.2 N/19 mm width, and adhesive force at peel angle of 180° to a copper lead frame after heating at 200°C for 1 hour of about 3.4 N/19 mm width. Furthermore, the tape had adhesive force at peel angle of 180° to an encapsulation resin after resin encapsulation of 4.1 N/19 mm.
The pressure-sensitive adhesive had 5% weight loss temperature of 320°C, and the amount of a gas generated after heating the pressure-sensitive adhesive at 200°C for 1 hour was 0.12 mg/g. Furthermore, the degree of heat shrinkage of the base material layer after heating at 180°C for 3 hours was 0.35%.

### Example 8

A pressure-sensitive adhesive tape was obtained in the same manner as in Example 1, except that a material obtained by adding 0.6 parts by weight of benzoyl peroxide as a crosslinking agent to 100 parts by weight of a silicone pressure-sensitive adhesive "SD-4284", manufactured by Dow Corning Toray Silicone Co., Ltd., was used as the pressure-sensitive adhesive. The tape had adhesive force to a copper lead frame of 7.0 N/19 mm width, and the pressure-sensitive adhesive had storage modulus at 200°C of 6.0×10⁴ Pa. The tape had adhesive force at peel angle of 180° to a copper lead frame after heating at 200°C for 1 hour of about 10.5 N/19 mm width. Furthermore, the tape had adhesive force at peel angle of 180° to an encapsulation resin after resin encapsulation of 12.3 N/19 mm.
The pressure-sensitive adhesive had 5% weight loss temperature of 310°C, and the amount of a gas generated after heating the pressure-sensitive adhesive at 200°C for 1 hour was 0.21 mg/g. Furthermore, the degree of heat shrinkage of the base material layer after heating at 180°C for 3 hours was 0.35%.

### Example 9

A heat-resistant pressure-sensitive adhesive tape was obtained in the same manner as in Example 1, except that a material obtained by adding 2 parts by weight of an isocyanate crosslinking agent as a crosslinking agent to a polymer in which 3 parts by weight of acrylic acid is copolymerized to 100 parts by weight of 2-ethylhexyl acrylate was used as the pressure-sensitive adhesive. The pressure-sensitive adhesive had storage modulus at 200°C of 7.0×10⁵ Pa, and 5% weight loss temperature of 230°C.
The tape had adhesive force at peel angle of 180° to a copper lead frame of 1.2 N/19 mm width, and adhesive force at peel angle of 180° to a copper lead frame after heating at 200°C for 1 hour of about 2.5 N/19 mm width. Furthermore, the tape had adhesive force at peel angle of 180° to an encapsulation resin after resin encapsulation of 5.5 N/19 mm.
The amount of a gas generated after heating the pressure-sensitive adhesive at 200°C for 1 hour was 0.65 mg/g. Furthermore, the degree of heat shrinkage of the base material layer after heating at 180°C for 3 hours was 0.35%.

### Example 10

A pressure-sensitive adhesive tape was obtained in the same manner as in Example 1, except that a material obtained by adding 2 parts by weight of a platinum catalyst to 100 parts by weight of a silicone pressure-sensitive adhesive "SD-4585", manufactured by Dow Corning Toray Silicone Co., Ltd., was used as the pressure-sensitive adhesive. The amount of a gas generated after heating the pressure-sensitive adhesive at 200°C for 1 hour was 1.2 mg/g. Furthermore, the pressure-sensitive adhesive had storage modulus at 200°C of 1.0×10⁵ Pa. The tape had adhesive force at peel angle of 180° to a copper lead frame of 1.3 N/19 mm width, and adhesive force at peel angle of 180° to a copper lead frame after heating at 200°C for 1 hour of about 2.0 N/19 mm width. Furthermore, the tape had adhesive force at peel angle of 180° to an encapsulation resin after resin encapsulation of 4.0 N/19 mm.
The pressure-sensitive adhesive had 5% weight loss temperature of 310°C, and the degree of heat shrinkage of the base material layer after heating at 180°C for 3 hours was 0.35%.

### Test Example 1

To the samples prepared above, wire bondability, masking property at resin encapsulation, and peelability of a tape were verified by the following methods. The results of each test are shown in Table 1 below.

### <Evaluation of wire bondability>

A heat-resistant pressure-sensitive adhesive tape was adhered to an outer pat side of a copper lead frame on which 4x4 pieces of one side 16 Pin type QFN having silver-plated terminal areas were arranged, using a tape laminating apparatus "PL-55TRM" (manufactured by Nitto Denko Corporation) at ordinary temperature. A semiconductor chip was adhered to a die pad area of the lead frame using an epoxy-phenol type silver paste, and fixed thereto by curing at 180°C for 1 hour.

The lead frame was fixed to a heat block heated to 200°C in a form of vacuum suction from the heat-resistant pressure-sensitive adhesive tape side, and then fixed by holding a peripheral part of the lead frame with a wind clamper. Those were wire-bonded with 25 µm diameter gold wire (GMG-25, manufactured by Tanaka Holdings Co., Ltd.) using a 115 KHz wire bonder (UTC-300B1, manufactured by Shinkawa Ltd.) under the following conditions.
First bonding pressure: 100 g
First bonding applied time: 10 milliseconds
Second bonding pressure: 150 g
Second bonding applied time: 15 milliseconds
Pull strength of the wire prepared by wire connection with the above method was measured with a pull tester (Bonding Tester PTR-30, manufactured by Rhesca Corporation). When the following two conditions were satisfied, it was evaluated as "Success", and the number of success wires/the number of all wires when wire bonding of 100 wires was performed to a lead frame in each sample was designated as "Success rate".

### (Conditions)

Condition 1: Fracture by pull test is not interfacial fracture of first bond (1st Bond) and second bond (2nd Bond).
Condition 2: Pull strength shows a value of 4 gf or more.

### <Evaluation of masking property>

A heat-resistant pressure-sensitive adhesive tape was adhered to an outer pat side of a copper lead frame on which 4×4 pieces of one side 16 Pin type QFN having silver-plated terminal areas were arranged.
The lead frame with the pressure-sensitive adhesive tape was wire-bonded under the above wire bonding conditions, and then molded with an epoxy encapsulation resin (HC-300, manufactured by Nitto Denko Corporation) at 175°C under the conditions of preheating: 40 seconds, injection time: 11.5 seconds and curing time: 120 seconds using a molding machine (Model-Y-series, manufactured by TOWA). The heat-resistant tape was peeled, and resin leakage was confirmed. The test was applied to 30 pieces of lead frames, and the proportion of occurrence of resin leakage was confirmed.

### <Evaluation of adhesive residue>

Encapsulation resin face of the tape peeled face of the sample for evaluation of the masking property, and lead frame face were visually observed. In Table 1, when adhesive residue was observed, it was designated as "+", and when adhesive residue was not observed, it was designated as "-". Furthermore, when measurement was impossible, it was designated as "ND".

### <Rework property>

A heat-resistant pressure-sensitive adhesive tape was adhered to an outer pat side of a copper lead frame on which 4x4 pieces of one side 16 Pin type QFN having silver-plated terminal areas were arranged, and peeled at peel angle of 180°. Shape of the lead frame after peeling the tape was confirmed. In Table 1, when deformation was not observed in the shape of the lead frame, it was designated as "Possible".

Properties of the tape prepared and evaluation results are shown in Table 1 below. The samples of Examples 1 to 5 were satisfied with all of properties. However, in Comparative Examples 1 and 2, because shrinkage of the base material layer occurred during wire bonding, sufficient wire bondability and masking property were not obtained.
In Example 6, the thickness of the pressure-sensitive adhesive layer was large and in Example 7, elastic modulus of the pressure-sensitive adhesive was low. Therefore, although the problem was not confirmed in the masking property of the encapsulation resin, sufficient wire bondability was not obtained.

In Example 8, adhesive force to the lead frame was too high. Therefore, when the tape was peeled, deformation of the lead frame was confirmed. Additionally, because adhesive force to the lead frame after heating and adhesive force to the encapsulation resin were high, when the tape was peeled, adhesive residue was confirmed on the lead frame and the encapsulation resin.

In Example 9, decomposition temperature of the pressure- sensitive adhesive was low. Therefore, when the tape was peeled after resin encapsulation, adhesive residue was confirmed on the lead frame and the encapsulation resin.

In Example 10, the amount of outgas was large. Therefore, wire bonding was impossible.

The results obtained above are shown in Table 1 below.
From the above results, there is obtained a heat-resistant pressure-sensitive adhesive tape which can suitably prevent resin leakage in an encapsulation step and is difficult to cause troubles in a series of steps in the production of MAP type where a lot of packages were simultaneously encapsulated.

**Table 1**

| | Unit | Ex. 1 | Ex. 2 | Ex. 3 | Ex. 4 | Ex. 5 | Ex. 6 |
|---|---|---|---|---|---|---|---|
| Tg of base material | °C | 402 | 421 | 402 | 402 | 402 | 406 |
| Thickness of base material (A) | µm | 25 | 25 | 50 | 25 | 25 | 12.5 |
| Thickness of pressure-sensitive adhesive (B) | µm | 6 | 6 | 6 | 15 | 6 | 40 |
| (B/A) | | 0.24 | 0.24 | 0.12 | 0.6 | 0.24 | 3.2 |
| Elastic modulus of pressure-sensitive adhesive | 10⁵ Pa | 4.0 | 4.0 | 4.0 | 4.0 | 10.0 | 4.0 |
| Coefficient of linear expansion of base material | 10⁻⁵/K⁻¹ | 2.7 | 1.6 | 2.7 | 2.7 | 2.7 | 2.7 |
| 5% Weight loss temperature | °C | 330 | 330 | 330 | 330 | 270 | 330 |
| Amount of gas generated | mg/g | 0.03 | 0.03 | 0.03 | 0.08 | 0.50 | 0.32 |
| Degree of heat shrinkage | % | 0.35 | 0.11 | 0.36 | 0.35 | 0.35 | 0.35 |
| Adhesive force to lead frame | N/19 mm | 1.0 | 1.1 | 1.3 | 1.8 | 0.5 | 3.8 |
| Adhesive force to lead frame (after heating) | N/19 mm | 2.7 | 2.8 | 3.0 | 4.2 | 1.5 | 5.5 |
| Adhesive force to Encapsulation resin | N/19 mm | 3.0 | 3.2 | 3.5 | 4.5 | 4.0 | 6.5 |
| Success rate of wire bonding | % | 100 | 100 | 100 | 100 | 100 | 25 |
| Success rate of masking | % | 100 | 100 | 100 | 100 | 100 | 100 |
| Adhesive residue (lead frame) | | - | - | - | - | - | - |
| Adhesive residue (encapsulation resin) | | - | - | - | - | - | - |
| Rework property | | Possible | Possible | Possible | Possible | Possible | Possible |

**Table 1 (Cont'd)**

| | Unit | Ex. 7 | Ex. 8 | Ex. 9 | Ex. 10 | Comp. Ex. 1 | Comp. Ex. 2 |
|---|---|---|---|---|---|---|---|
| Tg of base material | °C | 402 | 402 | 402 | 402 | 156 | 127 |
| Thickness of base material (A) | µm | 25 | 25 | 25 | 25 | 25 | 25 |
| Thickness of pressure-sensitive adhesive (B) | µm | 6 | 6 | 6 | 6 | 6 | 6 |
| (B/A) | | 0.24 | 0.24 | 0.24 | 0.24 | 0.24 | 0.24 |
| Elastic modulus of pressure-sensitive adhesive | 10⁵ Pa | 0.08 | 0.6 | 7.0 | 1.0 | 4.0 | 4.0 |
| Coefficient of linear expansion of base material | 10⁻⁵/K⁻¹ | 2.7 | 2.7 | 2.7 | 2.7 | 1.0 | 3.2 |
| 5% Weight loss temperature | °C | 320 | 310 | 230 | 310 | 330 | 330 |
| Amount of gas generated | mg/g | 0.12 | 0.21 | 0.65 | 1.20 | 0.03 | 0.03 |
| Degree of heat shrinkage | % | 0.35 | 0.35 | 0.35 | 0.35 | 0.42 | 1.90 |
| Adhesive force to lead frame | N/19 mm | 1.2 | 7.0 | 1.2 | 1.3 | 0.9 | 0.9 |
| Adhesive force to lead frame (after heating) | N/19 mm | 3.4 | 10.2 | 2.5 | 2.0 | 2.5 | 2.5 |
| Adhesive force to encapsulation resin | N/19 mm | 4.1 | 12.3 | 5.5 | 4.0 | 2.8 | 2.9 |
| Success rate of wire bonding | % | 30 | 100 | 100 | 0 | 0 | 0 |
| Success rate of masking | % | 100 | 100 | 100 | 100 | 0 | 0 |
| Adhesive residue (lead frame) | | - | + | + | - | ND | ND |
| Adhesive residue (encapsulation resin) | | - | + | + | - | ND | ND |
| Rework property | | Possible | Impossible | Possible | Possible | Possible | Possible |

### Example 11

A 25 µm thick polyimide film (KAPTON 100H (trade name), manufactured by Du pont-Toray Co., Ltd., Tg by the DMA method: 402°C) was used as a base material layer. 100 parts by weight of a silicone pressure-sensitive adhesive "SD-4586", manufactured by Dow Corning Toray Silicone Co., Ltd., and 2.5 parts by weight of a platinum catalyst were added to toluene and uniformly dispersed in toluene. The resulting dispersion was applied to the base material layer, followed by drying. Thus, a heat-resistant pressure-sensitive adhesive tape having about 10 µm thick pressure-sensitive adhesive layer was prepared. The pressure-sensitive adhesive was covered with Teflon (registered trademark) and dipped in toluene at room temperature for 1 week. Gel fraction before and after dipping was measured by weight change. As a result, the gel fraction was 72.1%.
The heat-resistant pressure-sensitive adhesive tape was adhered to an outer pad side of a copper lead frame on which 4x4 pieces of one side 16 Pin type QFN having silver-plated terminal areas were arranged (on the face of the lead frame opposite the face having the die pad) at ordinary temperature using a hand roller.

For the purpose of reproducing a heat treatment in a semiconductor chip mounting process, the lead frame was cured at 200°C for 1 hour.
The lead frame was fixed to a heat block heated to 225°C in a form of vacuum suction from the heat-resistant pressure-sensitive adhesive tape side, and the peripheral part of the lead frame was further fixed by holding with a wind clamper. Those were wire-bonded with a gold wire having a diameter of 25 µm (GMG-25, manufactured by Tanaka Holdings Co., Ltd.) using a 115 KHz wire bonder (UTC-300B1, manufactured by Shinkawa Ltd.) under the following conditions.
First bonding pressure: 100 g
First bonding applied time: 10 milliseconds
Second bonding pressure: 150 g
Second bonding applied time: 15 milliseconds

Those were molded with an epoxy encapsulation resin (HC-300B6, manufactured by Nitto Denko Corporation) at 175°C under the conditions of preheating set: 3 seconds, injection time: 12 seconds and curing time: 90 seconds using a molding machine (Model-Y-series, manufactured by TOWA). The heat-resistant pressure-sensitive adhesive tape was peeled. Thus, a QFN package was prepared.

### Example 12

100 parts by weight of a butyl acrylate monomer and 5 parts by weight of an acrylic acid monomer as a constituent monomer were copolymerized to obtain an acrylic copolymer. 1.0 part by weight of an epoxy crosslinking agent (Tetrad-C, manufactured by Mitsubishi Gas Chemical Company, Inc.) and 1.5 parts by weight of an isocyanate crosslinking agent (CORONATE-L, manufactured by Nippon Polyurethane Industry Co., Ltd.) were added to 100 parts by weight of the acrylic copolymer to prepare a pressure-sensitive adhesive composition. Gel fraction of the pressure-sensitive adhesive was measured in the same manner as in Example 11. The gel fraction was 97.8%. Thereafter, a QFN package was prepared in the same manner as in Example 11.

### Comparative Example 3

QFN package was prepared in the same manner as in Example 11, except that a 25 µm thick polyether imide film (SUPERIO LTT, manufactured by Mitsubishi Resin Co., Ltd., Tg: 239°C (according to the DMA method)) was used as the base material layer.

### Comparative Example 4

QFN package was prepared in the same manner as in Example 12, except that the same polyether imide film as used in Comparative Example 3 was used as the base material layer.

### Example 13

QFN package was prepared in the same manner as in Example 12, except that the epoxy crosslinking agent was not added to the pressure-sensitive adhesive layer. As a result of measuring gel fraction of the pressure-sensitive adhesive in the same manner as in Example 11, the gel fraction was 46.2%.

### Comparative Example 5

QFN package was prepared in the same manner as in Example 13, except that the same polyether imide film as used in Comparative Example 3 was used as the base material layer.

### Test Example 2

Success rate of wire bonding (shown as "W/B" in Table 2) and occurrence of adhesive residue when peeling a tape after completion of the process were measured in the QFN packages prepared above.
The success rate of wire bonding was obtained by performing wire bonding to all side 64 Pins of one side 16 Pin type QFN, and calculating from the number of Pins to which a wire could accurately be placed. The occurrence of adhesive residue was confirmed by visually observing the QFN package after peeling the tape.
The results obtained are shown in Table 2 below.

**Table 2**

| | Tg of base material layer (°C) | Gel fraction of pressure-sensitive adhesive (%) | Success rate of W/B (%) | Adhesive residue |
|---|---|---|---|---|
| Example 11 | 402 | 72.1 | 100 | None |
| Example 12 | 402 | 97.8 | 100 | None |
| Comparative Example 3 | 239 | 72.1 | 8 | None |
| Comparative Example 4 | 239 | 97.8 | 4 | None |
| Example 13 | 402 | 46.2 | 0 | Observed over entire surface |
| Comparative Example 5 | 239 | 46.2 | 0 | Observed over entire surface |

In Example 11, the success rate of wire bonding was mostly good, and the tape could be peeled without adhesive residue. In Example 12, the success rate of wire bonding was mostly good, and the tape could be peeled without adhesive residue, similar to Example 11.
In Comparative Examples 3 and 4, the tape could be peeled without adhesive residue. However, because the glass transition point (Tg) of the base material was close to the temperature in wire bonding, the success rate of wire bonding was decreased as compared with that in Examples 11 and 12.
In Example 13 and Comparative Example 5, because the gel fraction of the pressure-sensitive adhesive was low and elasticity thereof was low, wire bonding could not be performed at all, and adhesive residue occurred over the entire surface when peeling the tape.

From the above results, a heat-resistant pressure-sensitive adhesive tape for the production of a semiconductor device, which suppresses remarkable change of properties of a base material due to heat during use step, and can be peeled without adhesive residue after the use could be provided.

### Example 14

A 25 µm thick polyimide film (KAPTON 100H (trade name), manufactured by Du pont-Toray Co., Ltd.) was used as a base material layer. 100 parts by weight of a silicone pressure-sensitive adhesive (SD-4560, manufacture by Dow Coring Toray Silicone Co., Ltd.) and 2.5 parts by weight of a platinum catalyst were added to toluene and uniformly dissolved therein to prepare a dispersion. The dispersion was applied to one side of the base material layer, and dried to prepare a heat-resistant pressure-sensitive adhesive tape having a pressure-sensitive adhesive layer having a thickness of about 15 µm. PET separator having a thickness of about 50 µm (MRS-50S, manufactured by Mitsubishi Chemical Polyester Film Co., Ltd.) was adhered to the heat-resistant pressure-sensitive adhesive tape. Thus, a heat-resistant pressure-sensitive adhesive tape was prepared. The tape had separator peel force (peel strength) at peel angle of 180° of 0.20 N/50 mm, and separator peel force at peel angle of 90° of 0.30/50 mm (peel rate: 300 mm/min).

### Example 15

A 25 µm thick polyimide film (KAPTON 100H (trade name), manufactured by Du pont-Toray Co., Ltd.) was used as a base material layer. 100 parts by weight of a copolymer including butyl acrylate and acrylic acid (100 parts by weight and 5 parts by weight) and 0.4 part by weight of an epoxy crosslinking agent were added to toluene and uniformly dispersed therein to prepare a dispersion. The dispersion was applied to one side of the base material layer, and dried to prepare a heat-resistant pressure-sensitive adhesive tape having a pressure-sensitive adhesive layer having a thickness of about 15 µm. PET separator having a thickness of about 38 µm (#38 CERAPEEL, manufactured by Toray Advanced Film Co., Ltd.) was adhered to the heat-resistant pressure-sensitive adhesive tape. Thus, a heat-resistant pressure-sensitive adhesive tape was prepared. The tape had separator peel force at peel angle of 120° of 0.10 N/50 mm, and separator peel force at peel angle of 150° of 0.05/50 mm (peel rate: 300 mm/min).

### Example 16

A heat-resistant pressure-sensitive adhesive tape was obtained in the same manner as in Example 1, except that a PET separator having a thickness of about 38 µm (#38 CERAPEEL, manufactured by Toray Advanced Film Co., Ltd.) was used as a separator and adhered to the heat-resistant pressure-sensitive adhesive tape. The tape had separator peel force at peel angle of 180° of 1.80 N/50 mm, and separator peel force at peel angle of 90° of 2.40 N/50 mm (peel rate: 300 mm/min).

### Example 17

A heat-resistant pressure-sensitive adhesive tape was obtained in the same manner as in Example 2, except that a PET film having a thickness of about 38 µm ( LUMIRROR #38 S-10, manufactured by Toray Polyester Film Co., Ltd.) was used as a separator and adhered to the heat-resistant pressure-sensitive adhesive tape. The tape had separator peel force at peel angle of 120° of 3.50 N/50 mm, and separator peel force at peel angle of 150° of 3.0 N/50 mm (peel rate: 300 mm/min).

### Test Example 3

Each of the heat-resistant pressure-sensitive adhesive tapes produced in Examples 14 to 17 was adhered to an outer pad side of a copper lead frame on which one side 16 Pin type QFN are arranged in 4 units x 4 units using a lead frame burr-preventing mold masking tape laminating apparatus (PL-55TRM, manufactured by Nitto Seiki Co., Ltd.).
Thereafter, the following operations:
(a) bonding semiconductor chip, and curing (180°C, 1 hour)
(b) wire bonding
(c) molding (175°C, preheating: 40 seconds, injection time: 11.5 seconds, curing time: 120 seconds)
(d) peeling heat-resistant pressure-sensitive adhesive tape
(e) post-mold curing (175°C, 3 hours)
(f) cutting with dicer (individual dividing)
were conducted to obtain the individual QFN type semiconductor devices. Observation results regarding resin leakage of QFN thus obtained are shown in Table 3 below.

**Table 3**

| | Separator peel force (N/50 mm) | Tape adhering position (deviation distance) (mm) | Warpage of lead frame (warpage height) (mm) | Proportion of resin leakage (%) |
|---|---|---|---|---|
| Example 14 | 180° : 0.20 | 0 | 0 | 0 |
| | 90° : 0.30 | | | |
| Example 15 | 120° : 0.10 | 0 | 0 | 0 |
| | 150° : 0.05 | | | |
| Example 16 | 180° : 1.80 | 3 | 1 | 50 |
| | 90° : 2.40 | | | |
| Example 17 | 120° : 3.50 | 5 (wrinkles occurred) | 1.5 | 80 |
| | 150° : 3.00 | | | |

In the heat-resistant pressure-sensitive adhesive tapes of Examples 14 and 15, deviation of tape position and wrinkles after adhering the tape did not occur, and resin leakage when molding did not occur at all.
On the other hand, in the heat-resistant pressure-sensitive adhesive tapes of Examples 16 and 17, tape position deviated and wrinkles were generated when peeling the separator due to heavy separator peel force. Furthermore, warpage occurred in the lead frame by residual stress of the tape. As a result, the lead frame was not appropriately clamped when molding and resin leakage occurred in most parts.

The pressure-sensitive adhesive tape of the present invention suitably prevents resin leakage in an encapsulation step and is difficult to cause troubles in a series of steps even in MAP-QFN application, and is also excellent in peelability after resin encapsulation. Therefore, the tape can widely be used in a method for producing a semiconductor device.

While the present invention has been described in detail and with reference to specific embodiments thereof, it will be apparent to one skilled in the art that various changes and modifications can be made therein without departing from the scope thereof.

This application is based on Japanese patent application No. 2010-201905 filed September 9, 2010, the entire contents thereof being hereby incorporated by reference.

## Claims

1. A pressure-sensitive adhesive tape for resin encapsulation in production of a resin encapsulation type semiconductor device, the pressure-sensitive adhesive tape comprising:
a base material layer which does not have a glass transition temperature in a temperature region of 260°C or lower, and
a pressure-sensitive adhesive layer laminated on the base material layer.

2. The pressure-sensitive adhesive tape according to claim 1, wherein the base material layer does not have a glass transition temperature in a temperature region of 300°C or lower.

3. The pressure-sensitive adhesive tape according to claim 1 or 2,
wherein the base material layer has a thickness of from 5 to 100 µm.

4. The pressure-sensitive adhesive tape according to any one of claims 1 to 3, wherein the base material layer has a degree of heat shrinkage of 0.40% or less when heated at 180°C for 3 hours.

5. The pressure-sensitive adhesive tape according to any one of claims 1 to 4, wherein the pressure-sensitive adhesive layer is laminated on only one side of the base material layer.

6. The pressure-sensitive adhesive tape according to any one of claims 1 to 5, wherein the pressure-sensitive adhesive layer has a thickness of from 2 µm to 50 µm.

7. The pressure-sensitive adhesive tape according to any one of claims 1 to 6, wherein a ratio (B/A) of a thickness of the pressure-sensitive adhesive layer (B) to a thickness of the base material layer (A) is 3 or less.

8. The pressure-sensitive adhesive tape according to any one of claims 1 to 7, wherein a pressure-sensitive adhesive constituting the pressure-sensitive adhesive layer has a 5% weight loss temperature of 250°C or higher in accordance with a themogravimetric analysis under measurement conditions where a temperature rising rate is 10°C/min, an atmosphere gas is air and a gas flow rate is 200 ml/min.

9. The pressure-sensitive adhesive tape according to any one of claims 1 to 8, wherein an amount of a gas generated when a pressure-sensitive adhesive constituting the pressure-sensitive adhesive tape is heated at 200°C for 1 hour is 1.0 mg/g or less.

10. The pressure-sensitive adhesive tape according to any one of claims 1 to 9, having an adhesive force at a peel angle of 180° to a lead frame of from 0.05 to 6.0 N/19 mm width.

11. The pressure-sensitive adhesive tape according to any one of claims 1 to 10, having an adhesive force at a peel angle of 180° to a lead frame when heated at 200°C for 1 hour and then cooled to ordinary temperature of from 0.1 to 6.0 N/19 mm width.

12. The pressure-sensitive adhesive tape according to any one of claims 1 to 11, having an adhesive force at a peel angle of 180° to an encapsulation resin of 10.0 N/19 mm width or less.

13. The pressure-sensitive adhesive tape according to any one of claims 1 to 12, wherein the pressure-sensitive adhesive layer has a storage modulus at 200°C of 0.50×10⁵ Pa or more.

14. The pressure-sensitive adhesive tape according to any one of claims 1 to 13, wherein a pressure-sensitive adhesive constituting the pressure-sensitive adhesive layer is a silicone pressure-sensitive adhesive, an acrylic pressure-sensitive adhesive or a rubber pressure-sensitive adhesive.

15. The pressure-sensitive adhesive tape according to any one of claims 1 to 14, wherein a pressure-sensitive adhesive constituting the pressure-sensitive adhesive layer has a gel fraction of 60% or more.

16. The pressure-sensitive adhesive tape according to any one of claims 1 to 15, further comprising a release sheet in contact with the pressure-sensitive adhesive layer, the release sheet satisfying at least one of the following requirements (a) to (d):
(a) a peel strength at a peel angle 90°±15° being 1.5 N/50 mm width or less,
(b) a peel strength at a peel angle 120°±15° being 1.2 N/50 mm width or less,
(c) a peel strength at a peel angle 150°±15° being 1.0 N/50 mm width or less, and
(d) a peel strength at a peel angle 180°+0° and 180°-15° being 1.0 N/50 mm width or less.

17. The pressure-sensitive adhesive tape according to any one of claims 1 to 16, which is for use in a method for producing a resin encapsulation type semiconductor device, the method comprising:
adhering a pressure-sensitive adhesive tape to a face of a metal lead frame having a terminal part and a die pad, said face being opposite a face of the metal lead frame on which the die pad is provided;
die-bonding a semiconductor chip having an electrode pad onto the die pad of the metal lead frame;
electrically connecting a tip of the terminal part of the metal lead frame and the electrode pad on the semiconductor chip with a bonding wire; and
encapsulating the face of the metal lead frame on which the semiconductor chip is provided with an encapsulation resin.

18. A method for producing a resin encapsulation type semiconductor device, the method comprising:
adhering the pressure-sensitive adhesive tape according to any one of claims 1 to 16 to a face of a metal lead frame having a terminal part and a die pad, said face being opposite a face of the metal lead frame on which the die pad is provided;
die-bonding a semiconductor chip having an electrode pad onto the die pad of the metal lead frame;
electrically connecting a tip of the terminal part of the metal lead frame and the electrode pad on the semiconductor chip with a bonding wire; and
encapsulating the face of the metal lead frame on which the semiconductor chip is provided with an encapsulation resin.
